# FASCICULE DE BREVET EUROPEEN

(11) **EP 2 642 267 B1**
(45) Date de publication et mention de la délivrance du brevet: **23.08.2017**
(21) Numéro de dépôt: 13305332.2
(22) Date de dépôt: 19.03.2013
(51) Int. Cl.: G01M 3/20, F22B 1/06, C23C 14/56, C23C 14/24, C30B 23/06

(54) **Appareil de dépôt sous vide à cellules à vanne comportant un dispositif de détection de fuite et procédé de détection d'une fuite dans un appareil de dépôt sous vide**
Gerät zum Aufbringen durch Vakuumverdampfung mit Ventilzellen, das eine Leckerfassungsvorrichtung umfasst, und Leckerfassungsverfahren in einem solchen Vakuumbeschichtungsgerät
Vacuum deposition apparatus with valve cells comprising a leakage detection device and method for detecting a leak in a vacuum deposition apparatus

(30) Priorité: 20.03.2012 FR 1252499
(43) Date de publication de la demande: 25.09.2013
(73) Titulaire: Riber, 95870 Bezons (FR)
(72) Inventeur: Grange, Olivier, 92210 Saint-Cloud (FR)
(74) Mandataire: Jacobacci Coralis Harle

(56) Documents cités:
- WO-A1-02/081787
- JP-A- 7 014 766
- US-A- 5 777 209

## Description

L'invention concerne un appareil de dépôt sous vide comportant une cellule à vanne, un tube de transfert et une chambre de dépôt sous vide.

L'invention concerne plus particulièrement un appareil de dépôt sous vide muni d'un dispositif de détection de fuite à l'hélium.

Les appareils de dépôt sous vide sont largement utilisés dans l'industrie pour déposer des couches, parfois très minces, de matériaux sur des substrats de tailles variées.

Il est connu du document WO 02/081787 un appareil de dépôt sous vide à cellules à vanne comporte :
- au moins une cellule à vanne comprenant :
   - une enceinte externe,
   - un réservoir interne situé à l'intérieur de l'enceinte externe et adapté à contenir un matériau à évaporer,
   - une vanne de réservoir interne comprenant un port d'entrée de vanne en communication fluide avec le réservoir interne et un port de sortie de vanne,
- une chambre de dépôt sous vide,
- un tube de transfert comprenant un port d'entrée de tube connecté au port de sortie de vanne et un port de sortie de tube situé à l'intérieur de la chambre de dépôt sous vide, le port de sortie de tube comportant un injecteur adapté à générer un jet de vapeur du matériau à évaporer à l'intérieur de la chambre de dépôt sous vide, la chambre de dépôt sous vide étant raccordée à l'enceinte externe au moyen d'une bride de connexion, et
- des moyens de pompage adaptés à faire le vide à l'intérieur de la chambre de dépôt sous vide, les moyens de pompage comprenant une pompe primaire présentant une entrée de pompe primaire et une sortie de pompe primaire, et une pompe secondaire présentant une entrée de pompe secondaire et une sortie de pompe secondaire.

L'industrie microélectronique utilise par exemple un tel appareil de dépôt sous vide pour réaliser des dépôts de matériaux en utilisant des techniques du type épitaxie par jets moléculaires (MBE pour « *Molecular Beam Epitaxy »* en anglais) ou dépôt par jet moléculaire (MBD pour *« Molecular Beam Deposition »* en anglais). Des matériaux conducteurs (cuivre, zinc, nickel, chrome, par exemple), isolants (oxydes, nitrure, par exemple), ou semi-conducteurs (silicium, germanium, arsenic, phosphore, antimoine, gallium, indium, aluminium, par exemple) sont ainsi déposés sur des substrats de silicium, de germanium ou d'autres matériaux adéquats.

Les matériaux, élémentaires ou composés, et notamment les matériaux semi-conducteurs, qui sont utilisés dans ces appareils de dépôt sous vide sous une forme très pure, sont stockés dans des réservoirs internes fermés de grand volume permettant d'assurer un fonctionnement continu de ces appareils pendant de longues périodes et d'optimiser les coûts de production des composants semi-conducteurs fabriqués. Les prix de ces matériaux étant élevés, il est nécessaire d'éviter la perte inutile ou la dégradation irréversible de tout ou partie des volumes stockés dans les réservoirs internes.

Ainsi, les réservoirs internes de matériaux doivent être fermés de manière étanche afin, par exemple, d'empêcher toute fuite de vapeur du matériau à évaporer vers l'extérieur du réservoir interne ou d'empêcher toute oxydation ou autre réaction chimique avec un autre composé (eau, par exemple) pénétrant dans le réservoir interne. Ceci permet de ne pas perdre le contenu du réservoir interne, ce qui entraînerait des coûts supplémentaires d'exploitation.

De la même manière, la vanne de réservoir interne doit être étanche, c'est-à-dire qu'en position « fermée », elle bloque totalement l'écoulement du matériau à évaporer entre le réservoir interne et la chambre de dépôt sous vide. Ceci permet notamment de ne pas polluer la chambre de dépôt sous vide par le matériau à déposer lorsque cela n'est pas désiré, ce qui entraînerait des problèmes, par exemple lors du dépôt d'un autre matériau sur le substrat.

Les appareils de dépôt sous vide selon l'art antérieur ne permettent pas de vérifier l'étanchéité du réservoir interne ou de la vanne de réservoir interne rapidement et en toutes circonstances, en particulier en fonctionnement ou lors de l'utilisation de composés pyrophoriques.

Il n'est connu de l'art antérieur que des systèmes de détection de fuite permettant de tester l'étanchéité des autres organes de l'appareil, comme l'enceinte externe ou la chambre de dépôt sous vide, par exemple.

Afin de remédier à l'inconvénient précité de l'état de la technique, la présente invention propose un appareil de dépôt sous vide à cellules à vanne équipé d'un dispositif de détection de fuite permettant de tester l'étanchéité du réservoir interne et/ou de la vanne de réservoir interne, et ce avec un temps de réponse court et une dynamique de mesure élevée.

À cet effet, l'invention concerne un appareil de dépôt sous vide à cellules à vanne tel que décrit en introduction, l'appareil de dépôt sous vide étant caractérisé en ce qu'il comporte un dispositif de détection de fuite comprenant :
- des moyens d'injection de gaz adaptés à introduire de l'hélium dans la chambre de dépôt sous vide,
- des moyens de pompage de gaz adaptés à pomper l'hélium présent dans la chambre de dépôt sous vide,
- un détecteur d'hélium comprenant une entrée de détecteur, le détecteur d'hélium délivrant un signal représentatif du débit d'hélium le traversant,
- des moyens de mesure de pression adaptés à mesurer la pression à l'intérieur de la chambre de dépôt sous vide, et
- des moyens de traitement du signal adaptés à traiter le signal relatif au débit d'hélium délivré par le détecteur d'hélium et le signal délivré par les moyens de mesure de pression, pour délivrer un signal représentatif du taux de fuite de la vanne de réservoir interne, et en ce que les moyens de pompage comportent également :
   - une vanne de pompe secondaire placée entre la chambre de dépôt sous vide et l'entrée de pompe secondaire, par exemple *via* un chemin de haute conductance,
   - une vanne de pompe primaire placée entre la sortie de pompe secondaire et l'entrée de pompe primaire,
   - une vanne de dérivation placée entre la sortie de pompe secondaire et l'entrée du détecteur d'hélium, la dérivation étant faite avant la vanne de pompe primaire.

L'appareil de dépôt sous vide selon l'invention est ainsi agencé qu'il est possible :
- de fermer la vanne de pompe primaire lorsque la vanne de dérivation est ouverte, les gaz comprimés sortant de la sortie de pompe secondaire étant alors conduits vers l'entrée de détecteur, et
- de fermer la vanne de dérivation lorsque la vanne de pompe primaire est ouverte, les gaz comprimés sortant de la sortie de pompe secondaire étant alors conduits vers l'entrée de pompe primaire.

Ainsi, le dispositif selon l'invention permet d'utiliser les capacités combinées de pompage de la pompe secondaire et de la pompe primaire pour faire très rapidement le vide dans la chambre de dépôt sous vide, dès que la vanne de pompe secondaire s'ouvre et ainsi évacuer la majeure partie de l'hélium gazeux présent dans la chambre de dépôt sous vide. Cette quantité importante d'hélium ne sature alors pas le détecteur d'hélium du dispositif de détection de fuite qui usuellement comprend un spectromètre de masse.

De plus, lors de l'ouverture de la vanne de dérivation et de la fermeture de la vanne de pompe primaire, le détecteur d'hélium n'étant pas saturé par l'hélium, il peut effectuer très rapidement un test de détection de fuite, en utilisant toute la dynamique de mesure du détecteur.

Ainsi, une fuite de la vanne de réservoir interne est détectée avec un temps de réponse faible et une bonne précision.

L'utilisation de la vanne de pompe secondaire permet, lorsque cette vanne est fermée, de séparer l'appareil de dépôt sous vide des moyens de pompage de la chambre de dépôt sous vide, ceux-ci pouvant quand même fonctionner en continu afin que leurs capacités de pompage soient immédiatement disponibles lorsque la vanne de pompe secondaire s'ouvre.

Par ailleurs, d'autres caractéristiques avantageuses et non limitatives de l'appareil de dépôt sous vide selon l'invention sont les suivantes :
- les moyens de traitement du signal délivrent un signal représentatif du taux de fuite de la vanne de réservoir interne et du réservoir interne ;
- la vanne de réservoir interne est située à l'intérieur de l'enceinte externe, son port d'entrée de vanne étant connecté au réservoir interne ;
- le port d'entrée de tube du tube de transfert est situé à l'intérieur de l'enceinte externe, le tube de transfert traversant une première paroi de l'enceinte externe et une deuxième paroi de la chambre de dépôt sous vide ;
- les moyens de mesure de pression délivrent un signal représentatif de la pression à l'intérieur du réservoir interne ;
- l'enceinte externe est en communication fluide avec la chambre de dépôt sous vide ;
- il est prévu des moyens d'isolation adaptés à isoler l'enceinte externe de la chambre de dépôt sous vide ;
- les moyens d'isolation comprennent la vanne de réservoir interne ;
- les moyens d'isolation comprennent une soudure entre l'enceinte externe et le tube de transfert ;
- la pompe secondaire est une pompe turbomoléculaire ;
- la vanne de pompe secondaire est une vanne-tiroir ;
- la vanne de pompe secondaire est une vanne-papillon ou une vanne pendulaire ;
- les moyens d'injection de gaz du dispositif de détection de fuite sont également adaptés à introduire un gaz inerte dans la chambre de dépôt sous vide, le gaz inerte formant avec l'hélium un mélange gazeux ;
- le dispositif de détection de fuite comporte également des moyens de pilotage adaptés à commander les moyens d'injection de gaz et l'ouverture et la fermeture de la vanne de réservoir interne, de la vanne de pompe secondaire, de la vanne de pompe primaire et de la vanne de dérivation.

La présente invention présente plusieurs avantages. Elle permet une stabilisation très rapide du signal délivré par le détecteur d'hélium permettant la mesure avant que la pression dans le réservoir interne ne diminue significativement. Elle repousse également le domaine de pression dans lequel la diminution de pression dans le réservoir interne peut être reliée de manière pertinente à une fuite de ce réservoir interne.

L'appareil de dépôt sous vide selon l'invention permet de mesurer précisément les conductances de vanne de la vanne de réservoir interne et d'une bride de chargement de toutes les cellules à vanne installées sur l'appareil de dépôt sous vide, et ce, sur plusieurs décades et en quelques minutes.

Le dispositif de détection de fuite peut être utilisé sur des cellules à vanne à chaud, notamment dans des conditions nominales de température et de pression en fonctionnement, et sans remise à l'air des chambres de dépôt sous vide.

La plupart des détecteurs de fuite existants peuvent être utilisés avec les appareils de dépôt sous vide selon l'invention.

La pompe secondaire peut être installée à n'importe quel endroit de la ligne de pompage haute conductance et pas nécessairement avec une pompe secondaire installée sur la chambre de dépôt sous vide.

Le coût additionnel pour mettre en oeuvre un appareil de dépôt sous vide selon l'invention est très réduit lorsque l'utilisation d'une pompe secondaire et d'un détecteur de fuite existant est possible.

Sur un tel appareil de dépôt sous vide, le temps de réponse des tests de fuite externe des chambres de dépôt sous vide à vide de grand volume est nettement diminué et l'efficacité de la recherche de fuite est grandement améliorée.

L'invention concerne également un procédé de détection d'une fuite dans un appareil de dépôt sous vide à cellules à vanne, l'appareil de dépôt sous vide comportant :
- au moins une cellule à vanne comprenant :
   - une enceinte externe,
   - un réservoir interne situé à l'intérieur de l'enceinte externe, le réservoir interne contenant un matériau à évaporer,
   - une vanne de réservoir interne comprenant un port d'entrée de vanne en communication fluide avec le réservoir interne et un port de sortie de vanne,
- une chambre de dépôt sous vide, et
- un dispositif de détection de fuite,
le procédé de détection de fuite étant caractérisé en ce qu'il comporte :
- premièrement, une étape d'initialisation dans laquelle :
   - on réalise le vide à l'intérieur de la chambre de dépôt sous vide, puis
   - on mesure au moyen du dispositif de détection de fuite un débit de fuite initial dans la chambre de dépôt sous vide, et
- deuxièmement, une étape de mesure dans laquelle :
   - on ouvre la vanne de réservoir interne pour mettre la chambre de dépôt sous vide en communication fluide avec le réservoir interne, puis
   - on injecte un mélange gazeux dans la chambre de dépôt sous vide, puis
   - on mesure une pression P0 à l'intérieur du réservoir interne, puis
   - on ferme la vanne de réservoir interne, puis
   - on réalise le vide à l'intérieur de la chambre de dépôt sous vide jusqu'à une pression prédéterminée dans la chambre de dépôt sous vide, puis
   - on met en communication la chambre de dépôt sous vide avec le dispositif de détection de fuite, puis
   - on mesure un débit de fuite final dans la chambre de dépôt sous vide au moyen du dispositif de détection d'hélium, puis
   - on en déduit un taux de fuite du réservoir interne et/ou de la vanne de réservoir interne.

Par ailleurs, d'autres caractéristiques avantageuses et non limitatives du procédé de détection de fuite selon l'invention sont les suivantes :
- à l'issue de l'étape de mesure, on déduit le taux de fuite de la vanne de réservoir interne et du réservoir interne ;
- la vanne de réservoir interne de l'appareil de dépôt sous vide est située à l'intérieur de l'enceinte externe, son port d'entrée de vanne étant connecté au réservoir interne.

Des modes de réalisation de l'invention seront décrits en détail en référence aux dessins dans lesquels :
- la figure 1 est une vue schématique d'ensemble d'un appareil de dépôt sous vide selon un premier mode de réalisation conforme à l'invention ;
- la figure 2 est une vue schématique d'ensemble d'un appareil de dépôt sous vide selon un deuxième mode de réalisation ;
- la figure 3 est une vue schématique d'ensemble d'un appareil de dépôt sous vide selon un troisième mode de réalisation.

En préambule, précisons que dans l'exposé qui va suivre, les termes « haut » et « bas » seront utilisés relativement au local dans lequel l'appareil de dépôt sous vide est installé, le haut désignant le côté tourné vers le plafond du local et le bas désignant le côté tourné vers le plancher. De même, les termes « inférieur » et « supérieur » désigneront les côtés tournés respectivement vers le plancher et vers le plafond du local.

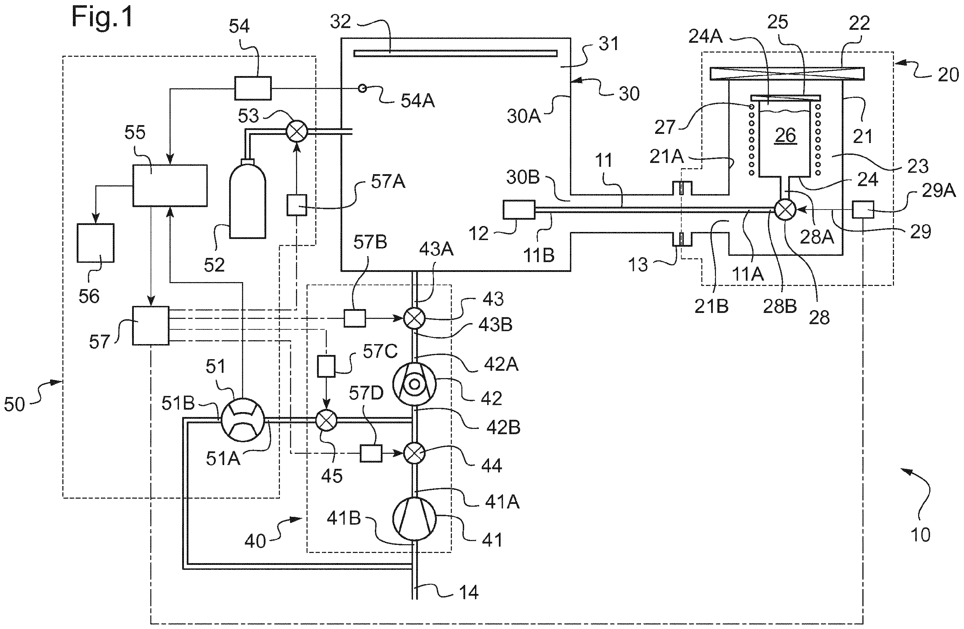

### Premier mode de réalisation (figure 1)

La figure 1 représente un appareil de dépôt sous vide 10 du type de ceux utilisés pour mettre en oeuvre des techniques de dépôt de couches par MBE.

Cet appareil de dépôt sous vide 10 comporte tout d'abord une source ou cellule à vanne 20. On considérera ici que l'appareil de dépôt sous vide 10 ne comporte qu'une seule cellule à vanne 20. Néanmoins, l'invention s'applique tout aussi bien à un appareil de dépôt sous vide comportant plusieurs cellules à vanne et l'homme du métier saura apporter les adaptations nécessaires à l'invention pour l'appliquer à un tel type d'appareil.

La cellule à vanne 20 comprend une enceinte externe 21 fermée généralement de manière étanche sur sa partie supérieure par une bride de cellule 22. Cette bride de cellule 22 est une bride dite « *froide* » dans la mesure où sa température est proche de la température ambiante régnant à l'extérieur de l'enceinte externe 21 et de l'appareil de dépôt sous vide 10. Dans les conditions standard de fonctionnement, la bride de cellule 22 présente une température comprise entre 20 °C et 250 °C.

L'enceinte externe 21 comporte des parois d'enceinte externe 21A qui définissent avec la bride de cellule 22 un volume d'enceinte externe 23. Lorsque la bride de cellule 22 ferme hermétiquement l'enceinte externe 21, la pression à l'intérieur de l'enceinte externe 21 est comprise entre 10⁻¹² et 10⁻³ millibar (mbar).

Lors d'une remise à l'air, c'est-à-dire lorsque l'on ouvre la bride de cellule 22, la pression à l'intérieur de l'enceinte externe 21 est égale à la pression régnant dans le local, sensiblement égale à 1013 mbar (soit environ 1 atmosphère).

Ainsi, comme l'appareil de dépôt sous vide 10 se trouve dans des conditions ambiantes où la pression à l'extérieur de l'enceinte externe 21 est sensiblement égale à 1013 mbar, la bride de cellule 22 doit assurer une étanchéité extrêmement importante entre le volume d'enceinte externe 23 et l'extérieur de l'enceinte externe 21, la différence de pression entre ces deux milieux étant très forte.

La cellule à vanne 20 comporte également un réservoir interne 24 entièrement situé à l'intérieur de l'enceinte externe 21, dans le volume d'enceinte externe 23. Le réservoir interne 24 est généralement disposé de manière verticale et fermé de manière étanche par une bride de chargement 25 située sur sa partie supérieure. Le réservoir interne 24 contient un matériau à évaporer 26, remplissant en partie le réservoir interne 24, laissant un volume libre 24A dans la partie haute du réservoir interne 24.

Dans le mode de réalisation représenté sur la figure 1, le matériau à évaporer 26 est de l'arsenic (symbole chimique As) qui est utilisé ici sous forme de morceaux solides d'arsenic.

En conditions normales, la pression dans le réservoir interne 24 est comprise entre 0.1 mbar et 10 mbar, la pression dépendant de la température à l'intérieur du réservoir interne 24.

En variante, le matériau à évaporer peut se présenter par exemple sous forme de lingots solides.

En variante encore, le matériau à évaporer peut être par exemple du phosphore, de l'antimoine, du sélénium, du souffre, du tellure, du magnésium ou des composés comme le tellure de cadmium (CdTe), le séléniure de zinc (ZnSe) ou le phosphure de gallium (GaP). En fonction des matériaux, ceux-ci peuvent être stockés à l'intérieur du réservoir interne sous forme solide ou liquide.

La bride de chargement 25 permet de recharger le réservoir interne 24 lorsque la quantité de matériau à évaporer 26 vient à manquer dans le réservoir interne 24. Pour réaliser cette opération de rechargement, un opérateur ouvre l'enceinte externe 21 en retirant la bride de cellule 22 puis ouvre le réservoir interne 24 en retirant la bride de chargement 25. L'opérateur peut alors remplir le réservoir interne 24 avec une nouvelle quantité de matériau à évaporer 26. L'opérateur referme ensuite le réservoir interne 24 au moyen de la bride de chargement 25 et referme enfin l'enceinte externe 21 au moyen de la bride de cellule 22.

À l'issue d'une étape de chargement (ou de rechargement) du réservoir interne 24, il est nécessaire de s'assurer que la bride de chargement 25 ferme de manière étanche le réservoir interne 24 et qu'aucune fuite n'est susceptible de se produire du réservoir interne 24 vers le volume d'enceinte externe 23. Nous verrons comment le mode de réalisation de l'appareil de dépôt sous vide 10 conforme à l'invention décrit ci-après permet de détecter une telle fuite sur le réservoir interne 24.

Le matériau à évaporer 26 contenu dans le réservoir interne 24 est chauffé par des moyens de chauffage 27 disposés à la périphérie du réservoir interne 24. Les moyens de chauffage 27 comportent ici des résistances chauffantes rayonnant sur le réservoir interne 24 et augmentant ainsi sa température. En condition de fonctionnement, le réservoir interne 24 est à une température comprise entre 50 °C et 600 °C.

La pression dans l'enceinte externe 21 étant faible lors du fonctionnement de l'appareil de dépôt sous vide 10, notamment lorsque les moyens de chauffage 27 rayonnent de la chaleur, les parois d'enceinte externe 21A restent froides, le vide relatif régnant dans le volume d'enceinte externe 23 limitant leur chauffage par conduction gazeuse depuis les moyens de chauffage 27.

Une fois que le matériau à évaporer 26 se trouve sous forme gazeuse grâce à l'augmentation de sa température par chauffage par les résistances chauffantes 27, les vapeurs du matériau à évaporer 26 sont conduites depuis la sortie du réservoir interne 24 jusqu'à une vanne de réservoir interne 28.

Comme représenté sur la figure 1, cette vanne de réservoir interne 28 est située à l'intérieur de l'enceinte externe 21 et comprend un port d'entrée de vanne 28A et un port de sortie de vanne 28B. Le port d'entrée de vanne 28A de la vanne de réservoir interne 28 est connectée à la sortie du réservoir interne 24.

En d'autres termes, le port d'entrée de vanne 28A est en communication fluide avec le réservoir interne 24.

Généralement, un clapet 29 relié à un piston permet d'ouvrir ou de fermer la vanne de réservoir interne 28, le clapet 29 étant commandé au moyen d'un actionneur 29A situé à l'extérieur de l'enceinte externe 21. Ainsi, la vanne de réservoir interne 28 est commandable de l'extérieur.

Lorsque la vanne de réservoir interne 28 est en position ouverte, elle laisse passer le matériau à évaporer 26, celui-ci pouvant s'écouler du port d'entrée de vanne 28A vers le port de sortie de vanne 28B.

Lorsque la vanne de réservoir interne 28 est en position fermée, elle empêche normalement tout écoulement du matériau à évaporer 26 du port d'entrée de vanne 28A vers le port de sortie de vanne 28B. Dans cette position fermée, la vanne de réservoir interne 28 est relativement étanche. Néanmoins, il est nécessaire de vérifier l'étanchéité de cette vanne de réservoir interne 28 afin de s'assurer qu'aucune fuite n'est susceptible de se produire, c'est-à-dire que le niveau de fuite est en-dessous d'un seuil de fuite tolérable.

Une telle fuite peut avoir lieu entre le port d'entrée de vanne 28A et le port de sortie de vanne 28B. On parle alors de fuite « en ligne », cette fuite caractérisant la position plus ou moins fermée de la vanne de réservoir interne 28.

Une autre fuite peut également avoir lieu de la vanne de réservoir interne 28 vers le volume d'enceinte externe 23, et donc entre le réservoir interne 24 et l'enceinte externe 21.

Nous verrons comment le mode de réalisation de l'appareil de dépôt sous vide 10 conforme à l'invention décrit ci-après permet également de détecter de telles fuites sur la vanne de réservoir interne 28.

L'actionneur 29A permet de commander de manière précise le clapet 29 de sorte que la vanne de réservoir interne 28 puisse prendre plusieurs positions, entre les deux postions extrêmes, ouverte et fermée.

Comme représenté sur la figure 1, l'appareil de dépôt sous vide 10 comporte également un tube de transfert 11, le tube de transfert 11 comprenant un port d'entrée de tube 11 A et un port de sortie de tube 11 B.

Le port d'entrée de tube 11A du tube de transfert 11 est situé à l'intérieur de l'enceinte externe 21 et est connecté au port de sortie de vanne 28B de la vanne de réservoir interne 28.

Comme représenté sur la figure 1, le tube de transfert 11 traverse une première paroi 21A de l'enceinte externe 21 au niveau d'une première ouverture 21B puis une deuxième paroi 30A d'une chambre de dépôt sous vide 30 au niveau d'une seconde ouverture 30B, de telle sorte que le port de sortie de tube 11 B du tube de transfert 11 est situé à l'intérieur de la chambre de dépôt sous vide 30, dans un volume de chambre 31.

La chambre de dépôt sous vide 30 est raccordée à l'enceinte externe 21 au moyen d'une bride de connexion 13. Dans le mode de réalisation particulier de l'invention représenté sur la figure 1, la bride de connexion 13 est telle que l'enceinte externe 21 communique avec la chambre de dépôt sous vide 30, le volume d'enceinte externe 23 et le volume de chambre 31 formant un volume d'appareil de dépôt sous vide.

L'enceinte externe 21 est donc ici en communication fluide avec la chambre de dépôt sous vide 30.

Ainsi, dans cette configuration, à l'équilibre statique, la pression dans le volume d'enceinte externe 23 et la pression dans le volume de chambre 31 sont identiques. Par la suite, on ne parlera donc plus que de la pression de chambre.

Ainsi agencés, le tube de transfert 11 permet de conduire les vapeurs du matériau à évaporer 26 depuis la cellule à vanne 20, et plus particulièrement depuis le port d'entrée de tube 11A du tube de transfert 11 connecté à la vanne de réservoir interne 28 qui n'est pas fermée, jusqu'à la chambre de dépôt sous vide 30 grâce à son port de sortie de tube 11 B.

La chambre de dépôt sous vide 30 comporte dans sa partie haute un substrat 32 sur lequel des couches de différents matériaux sont déposées, et notamment des couches du matériau à évaporer 26, qui est ici de l'arsenic.

À cet effet, le port de sortie de tube 11 B du tube de transfert 11 comporte un injecteur 12 dont la forme et les dimensions sont optimisées pour générer un jet de vapeur du matériau à évaporer 26 à l'intérieur de la chambre de dépôt 30, la forme, la direction et l'intensité du jet étant ajustées pour que la couche voulue de matériau à évaporer 26 se dépose sur le substrat 32.

Dans une variante du premier mode de réalisation, l'appareil de dépôt sous vide comprend une cellule à vanne comprenant une enceinte externe, un réservoir interne contenant un matériau à évaporer, et une vanne de réservoir interne de type « bonde ». Une telle source est par exemple la source de la société RIBER de la gamme « VCOR » vendue sous les références « VCOR 110 » ou « VCOR 300 ».

Une telle cellule à vanne est fabriquée en matériau de type PBN (nitrure de bore pyrolytique) afin de pouvoir être utilisée pour l'évaporation de matériaux corrosifs comme l'antimoine (Sb), le magnésium (Mg), le tellure (Te) ou le sélénium (Se). La vanne de réservoir interne est, selon cette variante, formée par une bonde de régulation permettant, dans un sens, l'écoulement du matériau à évaporer, et, dans un autre sens, le remplissage du réservoir interne.

Selon le mode de réalisation particulier de l'invention représenté sur la figure 1, l'appareil de dépôt sous vide 10 comporte également des moyens de pompage 40 permettant de faire le vide à l'intérieur de la chambre de dépôt sous vide 30 pour atteindre une pression de chambre comprise entre 10⁻³ et 10⁻¹² mbar, typiquement entre 10⁻⁸ et 10⁻¹² mbar.

Les moyens de pompage 40 comportent tout d'abord une pompe primaire 41 et une pompe secondaire 42, montées en série.

La pompe primaire 41 présente une entrée de pompe primaire 41A et une sortie de pompe primaire 41 B. La pompe primaire 41 est ici une pompe classique du type pompe à membrane. Une telle pompe primaire 41 permet d'atteindre des niveaux de vide avec des pressions descendant jusqu'à 10⁻³ mbar.

En variante, la pompe primaire peut être par exemple une pompe en spirale (« *scroll pump* » en anglais), une pompe à palette ou une pompe « *roots ».*

La sortie de pompe primaire 41 B est reliée à un conduit d'échappement 14 permettant d'évacuer tous les gaz pompés depuis l'appareil de dépôt sous vide 10 par les moyens de pompage 40.

La pompe secondaire 42 présente une entrée de pompe secondaire 42A et une sortie de pompe secondaire 42B ayant un débit sensiblement identique. Le rapport des pressions entre la sortie de pompe secondaire 42B et l'entrée de pompe secondaire 42A est ici supérieur à 10000 dans des conditions de fonctionnement normal.

Selon le mode de réalisation particulier de l'invention représenté sur la figure 1, la pompe secondaire 42 est une pompe turbomoléculaire. Cette pompe turbomoléculaire 42, qui est ici une pompe turbomoléculaire à multiples étages, permet d'atteindre des niveaux de vide avec des pressions dans la chambre de dépôt sous vide 30 comprises entre 10⁻³ mbar et 10⁻¹¹ mbar.

La pompe secondaire 42 est ici une pompe «à gros débit », avec une vitesse de pompage de l'ordre de 2000 litres par seconde. Le volume de l'appareil de dépôt sous vide 10 étant légèrement supérieur à 2000 litres, la majorité des gaz présents dans la chambre de dépôt sous vide 30, par exemple 99,99% des gaz, est pompé très rapidement, en 10 secondes environ.

Dans la configuration de la figure 1, les moyens de pompage 40 sont montés sur l'appareil de dépôt sous vide 10 au niveau de la chambre de dépôt sous vide 30.

En variante, les moyens de pompage peuvent être montés sur une autre chambre, par exemple une chambre de chargement ou de déchargement, une chambre de dégazage ou une chambre de distribution, cette autre chambre étant en communication fluide avec la chambre de dépôt sous vide de l'appareil de dépôt sous vide au moyen d'une ligne de haute conductance gazeuse.

Plus précisément, dans le mode de réalisation de l'invention illustré sur la figure 1, les moyens de pompage 40 comportent une vanne de pompe secondaire 43 placée entre la chambre de dépôt sous vide 30 et la pompe secondaire 42. Cette vanne de pompe secondaire 43 comporte une entrée de vanne de pompe secondaire 43A et une sortie de vanne de pompe secondaire 43B. L'entrée de vanne de pompe secondaire 43A est en communication avec la chambre de dépôt sous vide 30 et la sortie de vanne de pompe secondaire 43B est connectée à l'entrée de pompe secondaire 42A.

Préférentiellement, la vanne de pompe secondaire 43 est ici une vanne de type *« vanne-tiroir ».*

En variante, la vanne de pompe secondaire peut par exemple être une vanne-papillon ou une vanne pendulaire.

Lorsque la vanne de pompe secondaire 43 est ouverte et lorsque la pompe secondaire 42 fonctionne, alors un vide se forme à l'intérieur de la chambre de dépôt sous vide 30.

Lorsque la vanne de pompe secondaire 43 est fermée, elle isole la chambre de dépôt sous vide 30 du reste des moyens de pompage 40, et notamment de la pompe secondaire 42. Cependant, celle-ci peut continuer de fonctionner malgré la fermeture de la vanne de pompe secondaire 43.

En effet, la pompe secondaire 42 n'atteint son régime de fonctionnement optimal qu'après un certain temps, typiquement après 15 à 30 minutes. Ainsi, la pompe secondaire 42 n'est pas toujours arrêtée lorsque l'appareil de dépôt sous vide 10 fonctionne et lorsque la pression de chambre a atteint la valeur de consigne fixée par l'opérateur.

Les moyens de pompage 40 comportent également une vanne de pompe primaire 44 placée entre la sortie de pompe secondaire 42B et l'entrée de pompe primaire 41A. Cette vanne de pompe primaire 44, lorsqu'elle est ouverte, permet de mettre en communication la pompe secondaire 42 d'une part, et la pompe primaire 41 d'autre part.

Les moyens de pompage 40 comportent enfin une vanne de dérivation 45 placée à la sortie de la pompe secondaire 42. Plus particulièrement, la vanne de dérivation 45 est montée « en dérivation » de la sortie de pompe secondaire 42B, la dérivation étant faite avant la vanne de pompe primaire 44. Ceci permet notamment, lorsque la vanne de dérivation 45 est ouverte et lorsque la vanne de pompe primaire 44 est fermée, de conduire les gaz comprimés sortant de la sortie de pompe secondaire 42B vers la sortie de la vanne de dérivation 45. Ceci permet également, lorsque la vanne de dérivation 45 est fermée et lorsque la vanne de pompe primaire 44 est ouverte, de conduire les gaz comprimés sortant de la sortie de pompe secondaire 42B vers l'entrée de la pompe primaire 41A.

Comme représenté sur la figure 1, l'appareil de dépôt sous vide 10 comporte également un dispositif de détection de fuite 50.

La description qui va suivre sur le dispositif de détection de fuite 50 et sur son fonctionnement fera apparaître l'avantage à utiliser les moyens de pompage 40 tels qu'agencés et décrits précédemment afin de détecter des éventuelles fuites du réservoir interne 24, soit au niveau de sa bride de chargement 25, soit au niveau de sa vanne de réservoir interne 28.

Le dispositif de détection de fuite 50 comprend un détecteur d'hélium 51 comprenant une entrée de détecteur 51A et une sortie de détecteur 51 B.

Le dispositif de détection de fuite 50 comprend aussi des moyens de pompage de gaz (non représentée) permettant d'aspirer les gaz arrivant à l'entrée de détecteur 51A pour les éjecter vers la sortie de détecteur 51 B. Ces moyens de pompage de gaz sont généralement faibles. Ils ont ici une capacité de pompage d'environ 4 litres par seconde pour de l'hélium (130 litres par seconde pour de l'azote).

Comme représenté sur la figure 1, l'entrée de détecteur 51A est connectée à la sortie de la vanne de dérivation 45 et la sortie de détecteur 51 B est reliée au conduit d'échappement 14.

Le détecteur d'hélium 51 comprend généralement un spectromètre de masse (non représenté) permettant de mesurer la quantité d'hélium présente dans l'écoulement gazeux circulant entre l'entrée de détecteur 51A et la sortie de détecteur 51B. Le détecteur d'hélium 51 délivre ainsi un signal représentatif du débit d'hélium (en litre par seconde ou *l.s*⁻¹) le traversant.

Le détecteur d'hélium 51 est ici un détecteur de la société ADIXEN, vendu sous la référence ASM380. Le dispositif de détection de fuite 50 équipé d'un tel détecteur d'hélium 51 présente un seuil de détection du taux de fuite d'hélium (*« minimum detectable helium leak rate »* en anglais) autour de 5.10⁻¹² mbar.l.s⁻¹.

Le dispositif de détection de fuite 50 comporte également des moyens d'injection de gaz 52, 53 permettant d'introduire de l'hélium (hélium 4) dans la chambre de dépôt sous vide 30.

En variante, les moyens d'injections de gaz peuvent par exemple introduire d'autres gaz légers comme l'hélium 3 (³He : isotope de l'hélium 4) ou l'hydragène (H₂)

Dans le mode de réalisation particulier de l'appareil de dépôt sous vide 10 selon l'invention illustré sur la figure 1, les moyens d'injection de gaz 52, 53 du dispositif de détection de fuite 50 introduisent également un gaz inerte dans la chambre de dépôt sous vide 30, le gaz inerte formant avec l'hélium un mélange gazeux.

De manière alternative, les moyens d'injection de gaz peuvent par exemple être montés sur une autre chambre en communication fluide avec la chambre de dépôt sous vide de l'appareil de dépôt sous vide.

Le mélange gazeux introduit ici par les moyens d'injection de gaz 52, 53 est un mélange gazeux constitué d'hélium et de diazote (formule chimique N₂) avec une fraction molaire de 1000 ppm (ppm = partie par million) d'hélium.

Le mélange gazeux d'hélium et de diazote est stocké dans une bouteille 52 contenant le mélange gazeux à une pression comprise entre 1 bar et 250 bars et équipée d'un manodétendeur basse pression (non représenté).

Le mélange gazeux sortant de la bouteille 52 est alors généralement conduit jusqu'à une vanne d'injection 53 qui, si elle est ouverte, permet l'écoulement du mélange gazeux sous pression jusqu'à la chambre de dépôt sous vide 30.

Ainsi agencés, les moyens d'injection de gaz 52, 53 permettent d'injecter un mélange gazeux contenant au moins en partie de l'hélium dans la chambre de dépôt sous vide 30.

La chambre de dépôt sous vide 30 étant ici en communication avec le réservoir interne 24 lorsque la vanne de réservoir interne 28 est ouverte, les moyens d'injection de gaz 52, 53 permettent donc d'introduire le mélange gazeux à l'intérieur du réservoir interne 24.

De la même manière, comme dans le mode de réalisation particulier de l'invention représenté sur la figure 1, le volume de chambre 31 et le volume d'enceinte externe 23 communiquent entre eux, les moyens d'injection de gaz 52, 53 permettent également d'introduire le mélange gazeux à l'intérieur de l'enceinte externe 21. Le mélange gazeux occupe alors tout l'espace disponible, à savoir le volume d'enceinte externe 23 et le volume de chambre 31, qui sont en communication dans le cas représenté sur la figure 1.

En utilisant un tel mélange gazeux, avec une teneur en hélium extrêmement réduite, les tests de détection de fuite peuvent être effectués dans des conditions de pression plus élevée simulant ainsi le fonctionnement de l'appareil de dépôt sous vide 10 dans des conditions normales d'utilisation. Ainsi, pour une même pression de fonctionnement, on travaille avec une fraction molaire réduite d'hélium, et donc une pression partielle d'hélium réduite, ce qui limite les problèmes de saturation du détecteur d'hélium 51 lors d'un test de détection de fuite. On conserve ainsi la possibilité d'effectuer des tests de détection tout aussi rapidement qu'avec de l'hélium pur dans des conditions « d'arrêt » de l'appareil de dépôt sous vide 10.

Le dispositif de détection de fuite 50 comporte également des moyens de mesure de pression 54, 54A à l'intérieur de la chambre de dépôt sous vide 30. Ces moyens de mesure comprennent une jauge à vide combinée 54A placée à l'intérieur de la chambre de dépôt sous vide 30.

Cette jauge à vide combiné 54A comporte généralement :
- une jauge à vide secondaire de type *« jauge ionique Bayard-Alpert »* permettant de mesurer des pressions de chambre comprises entre 10⁻¹⁰ et 10⁻³ mbar ;
- une jauge à vide primaire de type *« sonde Pirani à convection »* permettant de mesurer des pressions de chambre comprises entre 10⁻⁴ et 1000 mbar

Ces moyens de mesure de pression 54, 54A permettent donc de mesurer des pressions de chambre comprises entre 10⁻¹⁰ et 1000 mbar, et cela, avec un temps de réponse de l'ordre de 10⁻³ seconde environ, voire jusqu'à 1 seconde environ.

À la fin de l'injection du mélange gazeux par les moyens d'injection de gaz 52, 53 dans la chambre de dépôt sous vide 30, lorsque la vanne de réservoir interne 28 est ouverte, que la vanne de pompe secondaire 43 est fermée et que le mélange gazeux remplit également le réservoir interne 24, les moyens de mesure de pression 54, 54A mesurent une pression de chambre qui est la même que la pression à l'intérieur du réservoir interne 24 qui est en équilibre statique avec la chambre de dépôt sous vide 30.

La jauge à vide combinée 54A est généralement pilotée par un contrôleur de jauge à vide 54 qui délivre un signal représentatif de la pression (en mbar) à l'intérieur de la chambre de dépôt sous vide 30.

Comme expliqué précédemment, lorsque le réservoir interne 24 est en communication avec la chambre de dépôt sous vide 30 grâce à l'ouverture de la vanne de réservoir interne 28, le mélange gazeux introduit dans la chambre de dépôt sous vide 30 remplit également le réservoir interne 24 de telle sorte que la pression à l'intérieur de la chambre de dépôt sous vide 30 soit égale à la pression à l'intérieur du réservoir interne 24.

Ainsi, le contrôleur de jauge à vide 54 délivre un signal qui est également représentatif de la pression (en mbar) à l'intérieur du réservoir interne 24.

Le dispositif de détection de fuite 50 comporte par ailleurs des moyens de traitement du signal 55 traitant le signal relatif au débit d'hélium délivré par le détecteur d'hélium 51 et le signal relatif à la pression dans le réservoir interne 24 délivré par les moyens de mesure de pression 54, 54A, pour délivrer un signal représentatif du taux de fuite du réservoir interne 24 et de la vanne de réservoir interne 28.

Dans le mode de réalisation particulier représenté sur la figure 1, le dispositif de détection de fuite 50 comporte également des moyens d'affichage 56 reliés aux moyens de traitement du signal 55 permettant à un opérateur de visualiser le résultat du test de détection de fuite mis en oeuvre par l'appareil de dépôt sous vide 10 selon l'invention.

Ces moyens d'affichage 56 comprennent ici un écran numérique.

Le dispositif de détection de fuite 50 comporte enfin de préférence des moyens de pilotage 57 commandant, d'une part, les moyens d'injection de gaz 52, 53 et, d'autre part, l'ouverture et la fermeture de la vanne de réservoir interne 28, de la vanne de pompe secondaire 43, de la vanne de pompe primaire 44 et de la vanne de dérivation 45.

Les moyens de pilotage 57 sont d'un côté reliés aux moyens de traitement du signal 55 qui lui fournissent des informations relatives aux taux de fuite mesurés du réservoir interne 24 et de la vanne de réservoir interne 28, et d'un autre côté reliés à quatre actionneurs 57A, 57B, 57C, et 57D pilotant respectivement la vanne d'injection 53, la vanne de pompe secondaire 43, la vanne de dérivation 45 et la vanne de pompe primaire 44.

En outre, les moyens de pilotage 57 sont reliés à l'actionneur de vanne de réservoir interne 29A qui pilote la vanne de réservoir interne 28.

Comme décrit précédemment pour l'actuateur de vanne de réservoir interne 29A, chacun des actionneurs 57A, 57B, 57C, et 57D permet de faire varier et de connaître le pourcentage d'ouverture de chacune des vannes pilotées 53, 43, 44, 45.

Les moyens de pilotage 57 sont notamment programmés pour piloter les actionneurs 57C et 57D de la vanne de dérivation 45 et de la vanne de pompe primaire 44 de manière à ce que :
- la vanne de pompe primaire 44 soit fermée lorsque la vanne de dérivation 45 est ouverte, les gaz comprimés sortant de la sortie de pompe secondaire 42B étant alors conduit vers l'entrée du détecteur d'hélium 51 A, et à ce que :
- la vanne de dérivation 45 soit fermée lorsque la vanne de pompe primaire 44 est ouverte, les gaz comprimés sortant de la sortie de pompe secondaire 42B étant alors conduit vers l'entrée de pompe primaire 41A.

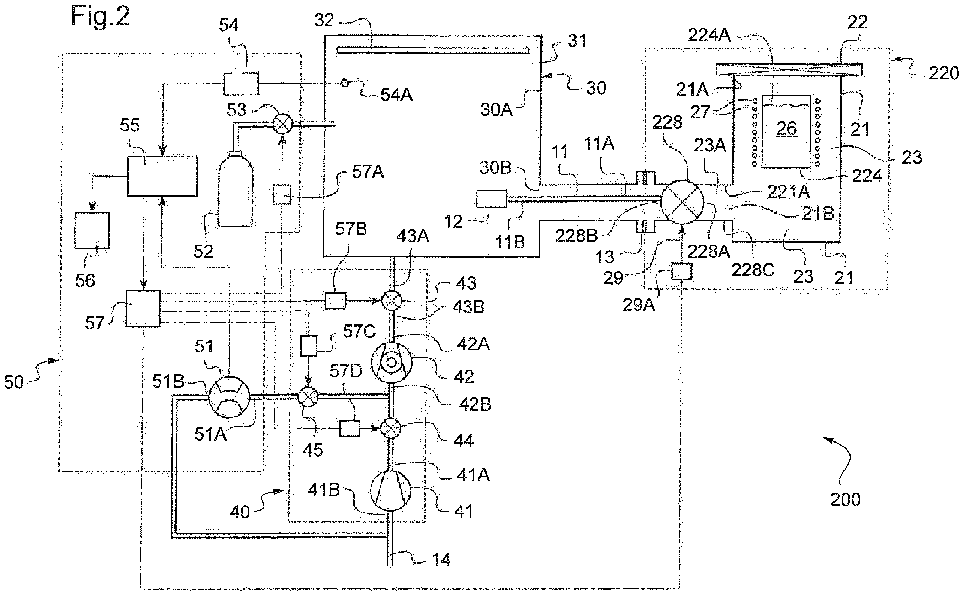

### Deuxième mode de réalisation (figure 2)

On a représenté sur la figure 2 une vue schématique d'ensemble d'un appareil de dépôt sous vide 200, selon un deuxième mode de réalisation, qui comprend une cellule à vanne 220 avec un réservoir interne 224 ouvert dans l'enceinte externe 21. Le volume libre 224A est donc en communication directe avec le volume d'enceinte externe 23 de l'enceinte externe 21. Ainsi, le réservoir interne 224 ne comprend aucune bride de chargement.

En variante, il peut être prévu des moyens de chauffage supplémentaires du réservoir interne situés à l'extérieur de l'enceinte externe.

En variante encore, et de manière avantageuse, les moyens de chauffage du réservoir interne peuvent être situés à l'extérieur de l'enceinte externe.

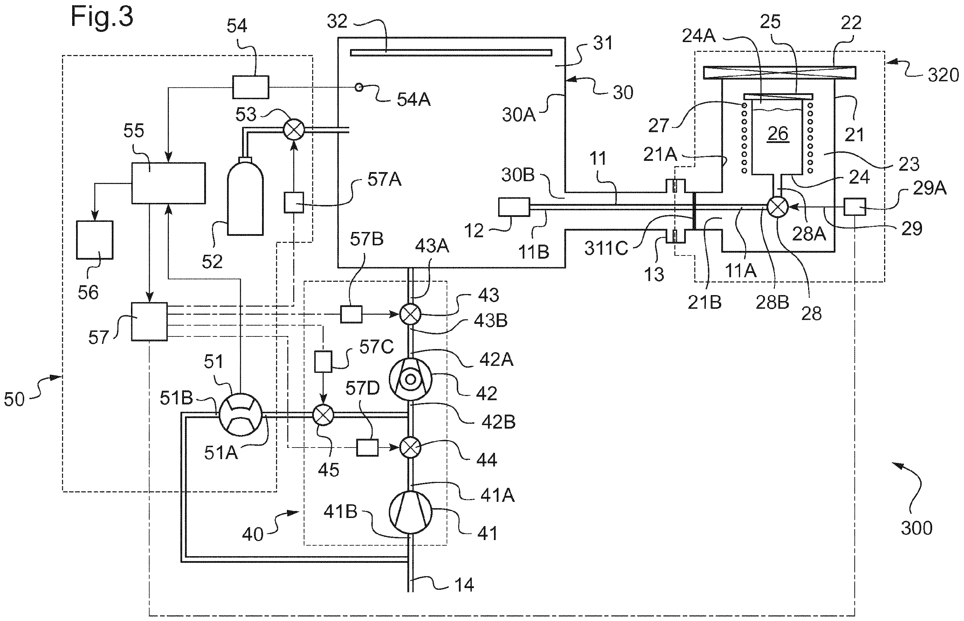

Lors du chauffage du réservoir interne 224 par les moyens de chauffage 27, le matériau à évaporer 26 s'évapore vers la partie haute du réservoir interne 224 pour remplir tout le volume d'enceinte externe 23, en particulier le volume particulier 23A compris entre la première ouverture 21B de l'enceinte externe 21 et le port d'entrée 228A de la vanne de réservoir interne 228 (voir figure 3). La vanne de réservoir interne 228 est donc en communication fluide avec le réservoir interne 224.

Comme représenté sur la figure 2, l'enceinte externe 21 comprend en effet un tube d'enceinte 221A reliant la première ouverture 21B au port d'entrée 228A de la vanne de réservoir interne 228.

Par ailleurs, la vanne de réservoir interne 228 forme l'une des extrémités d'un tube de vanne 228C, l'autre extrémité étant connectée à l'enceinte externe 21 au niveau de la première ouverture 21 B.

La vanne de réservoir interne 228 comprend également un port de sortie 228B connecté au tube de transfert 11 qui traverse la deuxième paroi 30A de la chambre de dépôt sous vide 30 (voir figure 2).

Dans ce deuxième mode de réalisation, la vanne de réservoir interne 228 permet également d'isoler l'enceinte externe 21 de la chambre de dépôt sous vide 30. En effet, en position fermée, la vanne de réservoir interne 228 empêche non seulement l'écoulement du matériau à évaporer depuis le volume particulier 23A vers le volume de chambre 31 de la chambre de dépôt sous vide 30, mais aussi la mise en communication fluide de l'enceinte externe 21 avec la chambre de dépôt sous vide 30.

### Troisième mode de réalisation (figure 3)

À la différence du premier mode de réalisation de l'appareil de dépôt sous vide 10 représenté sur la figure 1, il peut exister une soudure, par exemple au niveau de la bride de connexion, entre l'enceinte externe et le tube de transfert. Dans ce cas, la chambre de dépôt ne communique pas avec l'enceinte externe et les volumes de chambre et d'enceinte externe sont distincts.

On a ainsi représenté sur la figure 3 une vue schématique d'ensemble d'un appareil de dépôt sous vide 300, selon un troisième mode de réalisation, dans lequel l'enceinte externe 21 est également isolée de la chambre de dépôt sous vide 30.

En effet, comme représenté sur la figure 3, la cellule à vanne 320 diffère de la cellule à vanne 20 du premier mode de réalisation (voir figure 1) en ce qu'elle comprend des moyens d'isolation de l'enceinte externe 21.

Plus particulièrement, dans ce troisième mode de réalisation, il est prévu une soudure 311C étanche entre l'enceinte externe 21 et le tube de transfert 11.

Ainsi, dans cette configuration particulière, l'enceinte externe 21 n'est plus en communication fluide avec la chambre de dépôt sous vide 30, le volume d'enceinte externe 23 étant isolé du volume de chambre 31 grâce à la soudure 311C.

Dans ce troisième mode de réalisation, l'enceinte externe 21 est irrémédiablement isolée de la chambre de dépôt sous vide 30 grâce à la soudure 311C.

Cette configuration est différente de celle du deuxième mode de réalisation de l'appareil de dépôt sous vide 200 représenté sur la figure 2 où il était possible, malgré tout, de mettre en communication fluide la chambre de dépôt sous vide 30 avec l'enceinte externe 21 par l'ouverture de la vanne de réservoir interne 228,

### Procédé de détection de fuite dans les différents modes de réalisation de l'appareil de dépôt sous vide 10 : 200 ; 300

On décrira maintenant un procédé selon l'invention que l'opérateur peut mettre en oeuvre afin de pouvoir détecter une fuite du réservoir interne 24 ; 224 et/ou de la vanne de réservoir interne 28 ; 228.

Ce procédé de détection peut être avantageusement mise en oeuvre pour chacun des modes de réalisation de l'appareil de dépôt sous vide 10 ; 200 ; 300 précédemment décrits (voir figures 1 à 3).

Néanmoins, on comprend que :
- dans le premier mode de réalisation (voir figure 1), le procédé de détection de fuite selon l'invention teste globalement l'étanchéité de la vanne de réservoir interne 28 et du réservoir interne 24 (*i*.*e*. de sa bride de chargement 25) sans pouvoir distinguer l'origine d'une éventuelle fuite,
- dans le deuxième mode de réalisation (voir figure 2) où le réservoir interne 224 ne peut présenter de fuite, le procédé de détection de fuite selon l'invention teste uniquement l'étanchéité de la vanne de réservoir interne 228, et que
- dans le troisième mode de réalisation (voir figure 3) où l'enceinte externe 321 est isolée de la chambre de dépôt sous vide 30 grâce à la soudure 311C, le procédé de détection de fuite selon l'invention teste également uniquement l'étanchéité de la vanne de réservoir interne 28.

### 1) Étape d'initialisation

L'opérateur procède d'abord à une étape d'initialisation de l'appareil de dépôt sous vide 10 ; 200 ; 300 ayant pour but de mesurer le taux de fuite de l'hélium résiduel dans la chambre de dépôt sous vide 30. Pour cela, il effectue les opérations suivantes :
1a) Préparation de la cellule à vanne 20 ; 220 ; 320 à tester et du dispositif de détection de fuite 50
   - fermeture de la vanne de réservoir interne 28 ;228 et mise en place de la bride de chargement 25 (si présente) sur le réservoir interne 24 ; 224 ;
   - vérification de l'étanchéité de la bride de cellule 22 et de la chambre de dépôt sous vide 30 ;
   - fermeture de la vanne de pompe secondaire 43 ;
   - ouverture de la vanne de pompe primaire 44 et fermeture de la vanne de dérivation 45 ;
   - connexion du détecteur d'hélium 51 sur la vanne de dérivation 45 et mise en route du détecteur ;
   - préparation des moyens d'injection 52, 53 pour injecter le mélange gazeux He/N₂ et purge de la ligne d'injection.
1b) Mise sous vide de l'appareil de dépôt sous vide 10 ; 200 ; 300
   - ouverture de la vanne de réservoir interne 28 ; 228 ;
   - ouverture de la vanne de pompe secondaire 43 ;
   - mise en marche de la pompe primaire 41 et de la pompe secondaire 42 ;
   - attente jusqu'à ce que la pression dans la chambre de dépôt sous vide 30 soit inférieure à 10⁻⁵ mbar, de préférence inférieure à 10⁻⁶ mbar.
1c) Vérification du signal de base du détecteur d'hélium 51
   - fermeture de la vanne de pompe primaire 44 et ouverture de la vanne de dérivation 45 ;
   - mesure du taux de fuite de l'hélium résiduel dans la chambre de dépôt sous vide 30 et attente de la stabilisation du taux de fuite du réservoir interne 24 ; 224 et de la vanne de réservoir interne 28 ; 228 à une valeur inférieure à 10⁻¹⁰ mbar.l.s⁻¹ ;
   - consignation de la valeur initiale stabilisée précédente ;
   - ouverture de la vanne de pompe primaire 44 et fermeture de la vanne de dérivation 45.

### 2) Étape de mesure

Après l'étape d'initialisation, l'opérateur peut procéder à une étape de mesure ayant pour but de mesurer le taux de fuite du réservoir interne 24 ; 224 et/ou de la vanne de réservoir interne 28 ; 228. Pour cela, il met en oeuvre les opérations suivantes :
2a) Pressurisation de l'appareil de dépôt sous vide 10 ; 200 ; 300
   - vérification que toutes les températures sont inférieures à 800°C ;
   - fermeture de la vanne de pompe secondaire 43 et ouverture de la vanne de réservoir interne 28 ; 228 pour mettre la chambre de dépôt sous vide 30 en communication fluide avec le réservoir interne 24 ; 224 ;
   - injection grâce aux moyens d'injection 52, 53 d'un mélange gazeux hélium/azote à 1000 ppm de fraction molaire en hélium et remplissage de la chambre de dépôt sous vide 30 jusqu'à une pression de chambre de consigne comprise entre 10⁻⁴ et 10⁻¹ mbar ;
   - consignation de la pression statique P0 à l'intérieur du réservoir interne 24 ; 224 atteinte après une attente de 1 minute ;
2b) Pompage de l'appareil de dépôt sous vide 10 ; 200 ; 300
   - fermeture de la vanne de réservoir interne 28 ; 228 ;
   - ouverture de la vanne de pompe secondaire 43 ;
   - mise sous vide de la chambre de dépôt sous vide 30 jusqu'à ce que la pression de chambre soit inférieure à 10⁻⁶ mbar ;
2c) Mesure du taux de fuite du réservoir interne 24 ; 224 et/ou de la vanne de réservoir interne 28 ; 228
   - fermeture de la vanne de pompe primaire 44 et ouverture de la vanne de dérivation 45 ;
   - mesure du débit de fuite d'hélium au moyen du détecteur d'hélium 51 et calcul par le dispositif de détection de fuite 50 du taux de fuite (en mbar.l.s⁻¹) du réservoir interne 24 ; 224 et/ou de la vanne de réservoir interne 28 ; 228 ; consignation de la valeur finale atteinte après stabilisation.

À la fin de ces différentes opérations, l'opérateur possède une mesure du taux de fuite du réservoir interne 24 ; 224 et/ou de la vanne de réservoir interne 28 ; 228 en comparant les valeurs stabilisées du taux de fuite d'hélium obtenues à l'étape d'initialisation et à l'étape de mesure.

Dans le cas où, préalablement au procédé de détection de fuite, l'opérateur a mesuré par une méthode classique au cours du montage de l'appareil de dépôt sous vide 10 ; 200 ; 300, le débit de fuite de la vanne de réservoir interne 28 ; 228, il peut à partir de la mesure du taux de fuite « global » du réservoir interne 24 ; 224 et de la vanne de réservoir interne 28 ; 228, obtenu par le procédé précédemment décrit, en déduire le taux de fuite de la bride de chargement 25.

Ainsi, l'opérateur peut déterminer le couple de fermeture requis pour la vanne de réservoir interne 28 ; 228 pour obtenir un niveau d'étanchéité donné, sous réserve que la bride de chargement 25 soit suffisamment étanche. Ceci permet de notifier à l'utilisateur d'un tel appareil de dépôt sous vide 10 ; 200 ; 300 une valeur de couple de fermeture utile pour la vanne de réservoir interne 28 ; 228 qui ne soit pas excessive. En effet, la vanne de réservoir interne, qui est généralement une vanne en métal, s'abîme plus vite lorsqu'elle est fermée trop fortement.

La mesure du taux de fuite est rapide selon le procédé suivi par l'opérateur. En effet, lors de la fermeture de la vanne de pompe primaire 44 et de l'ouverture concomitante de la vanne de dérivation 45, une infime partie du mélange gazeux contenant seulement une fraction d'hélium pur parvient jusqu'au détecteur d'hélium 51 qui n'est alors pas saturé par la quantité d'hélium. La mesure du taux de fuite peut alors être faite très rapidement, typiquement en 1 seconde. De plus, en renouvelant la procédure ci-dessous, le détecteur d'hélium 51 et donc le dispositif de détection de fuite 50 peut être rapidement de nouveau opérationnel, par exemple pour détecter une fuite au niveau d'un autre réservoir interne contenant un autre matériau à évaporer ou bien pour mesurer le taux de fuite de la vanne de réservoir interne 28 ; 228 dans d'autres positions d'ouverture ou de fermeture.

## Revendications

1. Procédé de détection d'une fuite dans un appareil de dépôt sous vide (10) à cellules à vanne, l'appareil de dépôt sous vide (10) comportant au moins une cellule à vanne (20) comprenant :
- une enceinte externe (21),
- un réservoir interne (24 ; 224) situé à l'intérieur de l'enceinte externe (21), le réservoir interne (24 ; 224) contenant un matériau à évaporer (26),
- une vanne de réservoir interne (28 ; 228) comprenant un port d'entrée de vanne (28A ; 228A) en communication fluide avec le réservoir interne (24 ; 224) et un port de sortie de vanne (28B ; 228B),
- une chambre de dépôt sous vide (30), et
- un dispositif de détection de fuite (50),
ledit procédé de détection de fuite étant **caractérisé en ce qu'**il comporte :
- une étape d'initialisation dans laquelle :
- on réalise le vide à l'intérieur de la chambre de dépôt sous vide (30), puis
- on mesure au moyen du dispositif de détection de fuite (50) un débit de fuite initial dans la chambre de dépôt sous vide (30), et
- une étape de mesure dans laquelle :
- on ouvre la vanne de réservoir interne (28 ; 228) pour mettre la chambre de dépôt sous vide (30) en communication fluide avec le réservoir interne (24 ; 224), puis
- on injecte un mélange gazeux dans la chambre de dépôt sous vide (30), puis
- on mesure une pression P0 à l'intérieur du réservoir interne (24 ; 224), puis
- on ferme la vanne de réservoir interne (28 ; 228), puis
- on réalise le vide à l'intérieur de la chambre de dépôt sous vide (30) jusqu'à une pression prédéterminée dans la chambre de dépôt sous vide (30), puis
- on met en communication la chambre de dépôt sous vide (30) avec le dispositif de détection de fuite (50), puis
- on mesure un débit de fuite final dans la chambre de dépôt sous vide (30) au moyen du dispositif de détection de fuite (50), puis
- on en déduit un taux de fuite de la vanne de réservoir interne (28 ; 228).

2. Procédé de détection d'une fuite selon la revendication 1, selon lequel, à l'issue de l'étape de mesure, on déduit le taux de fuite de la vanne de réservoir interne (28 ; 228) et du réservoir interne (24 ; 224).

3. Appareil de dépôt sous vide (10 ; 200 ; 300) à cellules à vanne adapté à mettre en oeuvre le procédé de détection de fuite selon l'une des revendications 1 et 2 et comportant :
- au moins une cellule à vanne (20 ; 220 ; 320) comprenant :
- une enceinte externe (21),
- un réservoir interne (24 ; 224) situé à l'intérieur de l'enceinte externe (21) et adapté à contenir un matériau à évaporer (26),
- une vanne de réservoir interne (28 ; 228) comprenant un port d'entrée de vanne (28A ; 228A) en communication fluide avec le réservoir interne (24 ; 224) et un port de sortie de vanne (28B ; 228B),
- une chambre de dépôt sous vide (30),
- un tube de transfert (11) comprenant un port d'entrée de tube (11A) et connecté au port de sortie de vanne (28B ; 228B) de la vanne de réservoir interne (28 ; 228) et un port de sortie de vanne (11 B), de telle sorte que le port de sortie de tube (11 B) soit situé dans la chambre de dépôt sous vide (30), le port de sortie de tube (11 B) comportant un injecteur (12) adapté à générer un jet de vapeur du matériau à évaporer (26) à l'intérieur de la chambre de dépôt sous vide (30), la chambre de dépôt sous vide (30) étant raccordée à l'enceinte externe (21) au moyen d'une bride de connexion (13),
- des moyens de pompage (40) adaptés à faire le vide à l'intérieur de la chambre de dépôt sous vide (30), les moyens de pompage (40) comprenant :
- une pompe primaire (41) présentant une entrée de pompe primaire (41A) et une sortie de pompe primaire (41 B), et
- une pompe secondaire (42) présentant une entrée de pompe secondaire (42A) et une sortie de pompe secondaire (42B), la sortie de pompe secondaire (42B) étant connectée à l'entrée de pompe primaire (41A),
**caractérisé en ce qu'**il comporte un dispositif de détection de fuite (50) comprenant :
- des moyens d'injection de gaz (52, 53) adaptés à introduire de l'hélium dans la chambre de dépôt sous vide (30),
- des moyens de pompage de gaz adaptés à pomper l'hélium présent dans la chambre de dépôt sous vide (30),
- un détecteur d'hélium (51) comprenant une entrée de détecteur (51A), le détecteur d'hélium (51) délivrant un signal représentatif du débit d'hélium le traversant,
- des moyens de mesure de pression (54, 54A) adaptés à mesurer la pression à l'intérieur de la chambre de dépôt sous vide (30), et
- des moyens de traitement du signal (55) adaptés à traiter le signal relatif au débit d'hélium délivré par le détecteur d'hélium (51) et le signal délivré par les moyens de mesure de pression (54, 54A), pour délivrer un signal représentatif du taux de fuite de la vanne de réservoir interne (28 ; 228),
et **en ce que** les moyens de pompage (40) comportent également :
- une vanne de pompe secondaire (43) placée entre la chambre de dépôt sous vide (30) et l'entrée de pompe secondaire (42A),
- une vanne de pompe primaire (44) placée entre la sortie de pompe secondaire (42B) et l'entrée de pompe primaire (41A), et
- une vanne de dérivation (45) placée entre la sortie de pompe secondaire (42B) et l'entrée de détecteur (51A), la dérivation étant faite avant la vanne de pompe primaire (44).

4. Appareil de dépôt sous vide (10 ; 300) selon la revendication 3, dans lequel la vanne de réservoir interne (28) est située à l'intérieur de l'enceinte externe (21), son port d'entrée de vanne (28A) étant connecté au réservoir interne (24).

5. Appareil de dépôt sous vide (10; 300) selon l'une des revendications 3 et 4, dans lequel le port d'entrée de tube (11A) du tube de transfert (11) est situé à l'intérieur de l'enceinte externe (21), le tube de transfert (11) traversant une première paroi (21A) de l'enceinte externe (21) et une deuxième paroi (30A) de la chambre de dépôt sous vide (30).

6. Appareil de dépôt sous vide (10) selon l'une des revendications 3 à 5, dans lequel :
- les moyens de mesure de pression (54, 54A) délivrent un signal représentatif de la pression à l'intérieur du réservoir interne (24), et
- les moyens de traitement du signal (55) traitent le signal représentatif de la pression à l'intérieur du réservoir interne (24) délivré par les moyens de mesure de pression (54, 54A) pour délivrer un signal représentatif du taux de fuite de la vanne de réservoir interne (28) et du réservoir interne (24).

7. Appareil de dépôt sous vide (10) selon l'une des revendications 3 à 6, dans lequel l'enceinte externe (21) est en communication fluide avec la chambre de dépôt sous vide (30).

8. Appareil de dépôt sous vide (200 ; 300) selon l'une des revendications 3 à 6, dans lequel il est prévu des moyens d'isolation (228 ; 311C) adaptés à isoler l'enceinte externe (21) de la chambre de dépôt sous vide (30).

9. Appareil de dépôt sous vide (200) selon la revendication 8, dans lequel les moyens d'isolation comprennent la vanne de réservoir interne (228).

10. Appareil de dépôt sous vide (300) selon la revendication 8, dans lequel les moyens d'isolation comprennent une soudure (311C) entre l'enceinte externe (21) et le tube de transfert (11).

11. Appareil de dépôt sous vide (10 ; 200 ; 300) selon l'une des revendications 3 à 10, dans lequel la pompe secondaire (42) est une pompe turbomoléculaire.

12. Appareil de dépôt sous vide (10 ; 200; 300) selon l'une des revendications 3 à 11, dans lequel la vanne de pompe secondaire (43) est une vanne-tiroir.

13. Appareil de dépôt sous vide selon l'une des revendications 3 à 11, dans lequel la vanne de pompe secondaire est une vanne-papillon ou une vanne pendulaire.

14. Appareil de dépôt sous vide (10 ; 200 ; 300) selon l'une des revendications 3 à 13, dans lequel les moyens d'injection de gaz (52, 53) du dispositif de détection de fuite (50) sont également adaptés à introduire un gaz inerte dans la chambre de dépôt sous vide (30), le gaz inerte formant avec l'hélium un mélange gazeux.

15. Appareil de dépôt sous vide (10 ; 200 ; 300) selon l'une des revendications 3 à 14, dans lequel le dispositif de détection de fuite (50) comporte également des moyens de pilotage (57) adaptés à commander les moyens d'injection de gaz (52, 53) et l'ouverture et la fermeture de la vanne de réservoir interne (28 ; 228), de la vanne de pompe secondaire (43), de la vanne de pompe primaire (44) et de la vanne de dérivation (45).

## Patentansprüche

1. Leckerfassungsverfahren in einem Vakuumbeschichtungsgerät (10) mit Ventilzellen, wobei das Vakuumbeschichtungsgerät (10) wenigstens eine Ventilzelle (20) aufweist, die
- ein äußeres Gehäuse (21),
- einen im Inneren des äußeren Gehäuses (21) gelegenen inneren Tank (24; 224), wobei der innere Tank (24; 224) ein zu verdampfendes Material (26) enthält,
- ein Ventil (28; 228) für den inneren Tank, das einen mit dem inneren Tank (24; 224) in fluider Verbindung stehenden Ventileingangsanschluß (28A; 228A) und einen Ventilausgangsanschluß (28B; 228B) aufweist,
- eine Vakuumbeschichtungskammer (30) und
- eine Leckerfassungsvorrichtung (50)
aufweist,
wobei das Leckerfassungsverfahren **dadurch gekennzeichnet ist, daß** es
- einen Initialisierungsschritt, bei dem man
- das Vakuum im Inneren der Vakuumbeschichtungskammer (30) schafft und dann
- mit Hilfe der Leckerfassungsvorrichtung (50) einen Anfangsleckfluß in der Vakuumbeschichtungskammer (30) mißt, und
- einen Meßschritt, bei dem man
- das Ventil (28; 228) für den inneren Tank öffnet, um die Vakuumbeschichtungskammer (30) mit dem inneren Tank (24; 224) in fluide Verbindung zu setzen, dann
- ein Gasgemisch in die Vakuumbeschichtungskammer (30) einspritzt,
- einen Druck P0 im Inneren des inneren Tanks (24; 224) mißt, dann
- das Ventil (28; 228) für den inneren Tank schließt, dann
- das Vakuum im Inneren der Vakuumbeschichtungskammer (30) bis zu einem vorbestimmten Druck in der Vakuumbeschichtungskammer (30) herstellt, dann
- die Vakuumbeschichtungskammer (30) in fluide Verbindung mit der Leckerfassungsvorrichtung (50) bringt, dann
- mit Hilfe der Leckerfassungsvorrichtung (50) einen Endleckfluß in der Vakuumbeschichtungskammer (30) mißt, dann
- daraus ein Maß für das Leck des Ventils (28; 228) für den inneren Tank ableitet.

2. Leckerfassungsverfahren gemäß Anspruch 1, bei dem man am Ende des Meßschritts das Maß für das Leck des Ventils (28; 228) für den inneren Tank und des inneren Tanks (24; 224) ableitet.

3. Vakuumbeschichtungsgerät (10; 200; 300) mit Ventilzellen, das für die Durchführung des Leckerfassungsverfahrens gemäß einem der Ansprüche 1 und 2 ausgelegt ist und
- wenigstens eine Ventilzelle (20; 220; 320), die
- ein äußeres Gehäuse (21),
- einen im Inneren des äußeren Gehäuses (21) gelegenen und zum Enthalten eines zu verdampfenden Materials ausgelegten inneren Tank (24; 224),
- ein Ventil (28; 228) für den inneren Tank, das einen mit dem inneren Tank (24; 224) in fluider Verbindung stehenden Ventileingangsanschluß (28A; 228A) und einen Ventilausgangsanschluß (28B; 228B)
aufweist,
- eine Vakuumbeschichtungskammer (30),
- ein Transferrohr (11), das einen Rohreingangsanschluß (11A) aufweist und mit dem Ventilausgangsanschluß (28B; 228B) des Ventils (28; 228) für den inneren Tank verbunden ist und einen Rohrausgangsanschluß (11B) aufweist, so daß der Rohrausgangsanschluß (11B) in der Vakuumbeschichtungskammer (30) gelegen ist, wobei der Rohrausgangsanschluß (11B) eine Einspritzvorrichtung (12) aufweist, die dazu ausgelegt ist, einen Dampfstrahl des zu verdampfenden Materials (26) im Inneren der Vakuumbeschichtungskammer (30) zu erzeugen, wobei die Vakuumbeschichtungskammer (30) mittels eines Verbindungsflansches (13) mit dem äußeren Gehäuse (21) verbunden ist,
- Pumpmittel (40), die dazu ausgelegt sind, das Vakuum im Inneren der Vakuumbeschichtungskammer (30) zu schaffen, wobei die Pumpmittel (40)
- eine Primärpumpe (41), die einen Primärpumpeneingang (41A) und einen Primärpumpenausgang (41B) aufweist, und
- eine Sekundärpumpe (42), die einen Sekundärpumpeneingang (42A) und einen Sekundärpumpenausgang (42B) aufweist, wobei der Sekundärpumpenausgang (42B) mit dem Primärpumpeneingang (41A) verbunden ist,
aufweist,
**dadurch gekennzeichnet, daß** es eine Leckerfassungsvorrichtung (50) aufweist, die
- Gaseinspritzmittel (52, 53), die zum Einbringen des Heliums in die Vakuumbeschichtungskammer (30) ausgelegt sind,
- Gaspumpmittel, die zum Pumpen des in der Vakuumbeschichtungskammer (30) vorhandenen Heliums ausgelegt sind,
- einen Heliumdetektor (51), der einen Detektoreingang (51A) aufweist, wobei der Detektoreingang (51A) ein für den diesen durchströmenden Heliumfluß repräsentatives Signal abgibt,
- Druckmeßmittel (54, 54A), die dazu ausgelegt sind, den Druck im Inneren der Vakuumbeschichtungskammer (30) zu messen, und
- Mittel (55) zum Verarbeiten des Signals, die dazu ausgelegt sind, das vom Heliumdetektor (51) abgegebene, auf den Heliumfluß bezogene Signal und das von den Druckmeßmitteln (54, 54A) abgegebene Signal zu verarbeiten, um ein für das Maß des Lecks des Ventils (28; 228) für den inneren Tank repräsentatives Signal abzugeben,
aufweist,
und **dadurch gekennzeichnet, daß** die Pumpmittel (40) außerdem
- ein zwischen der Vakuumbeschichtungskammer (30) und dem Sekundärpumpeneingang (42A) angeordnetes Sekundärpumpenventil (43),
- ein zwischen dem Sekundärpumpenausgang (42B) und dem Primärpumpeneingang (41A) angeordnetes Primärpumpenventil (44) und
- ein zwischen dem Sekundärpumpenausgang (42B) und dem Detektoreingang (51A) angeordnetes Umlenkungsventil (45), wobei die Umlenkung vor dem Primärpumpenventil (44) erfolgt, aufweisen.

4. Vakuumbeschichtungsgerät (10; 300) gemäß Anspruch 3, bei dem das Ventil (28) für den inneren Tank im Inneren des äußeren Gehäuses (21) angeordnet ist, wobei dessen Ventileingangsanschluß (28A) mit dem inneren Tank (24) verbunden ist.

5. Vakuumbeschichtungsgerät (10; 300) gemäß einem der Ansprüche 3 und 4, bei dem der Rohreingangsanschluß (11A) des Transferrohrs (11) im Inneren des äußeren Gehäuses (21) angeordnet ist, wobei das Transferrohr (11) eine erste Wandung (21A) des äußeren Gehäuses (21) und eine zweite Wandung (30A) der Vakuumbeschichtungskammer (30) durchquert.

6. Vakuumbeschichtungsgerät (10) gemäß einem der Ansprüche 3 bis 5, bei dem
die Druckmeßmittel (54, 54A) ein für den Druck im Inneren des inneren Tanks (24) repräsentatives Signal abgeben und
die Signalverarbeitungsmittel (55) das von den Druckmeßmitteln (54, 54A) abgegebene, für den Druck im Inneren des inneren Tanks (24) repräsentative Signal verarbeiten, um ein für das Maß des Lecks des Ventils (28) für den inneren Tank und des inneren Tanks (24) repräsentatives Signal abzugeben.

7. Vakuumbeschichtungsgerät (10) gemäß einem der Ansprüche 3 bis 6, bei dem das äußere Gehäuse (21) in fluider Verbindung mit der Vakuumbeschichtungskammer (30) steht.

8. Vakuumbeschichtungsgerät (200; 300) gemäß einem der Ansprüche 3 bis 6, bei dem Trennmittel (228; 311C) vorgesehen sind, die dazu ausgelegt sind, das äußere Gehäuse (21) von der Vakuumbeschichtungskammer (30) zu trennen.

9. Vakuumbeschichtungsgerät (200) gemäß Anspruch 8, bei dem die Trennmittel das Ventil (228) für den inneren Tank aufweisen.

10. Vakuumbeschichtungsgerät (300) gemäß Anspruch 8, bei dem die Trennmittel eine Schweißnaht (311C) zwischen dem äußeren Gehäuse (21) und dem Transferrohr (11) aufweisen.

11. Vakuumbeschichtungsgerät (10; 200; 300) gemäß einem der Ansprüche 3 bis 10, bei dem die Sekundärpumpe (42) eine turbomolekulare Pumpe ist.

12. Vakuumbeschichtungsgerät (10; 200; 300) gemäß einem der Ansprüche 3 bis 11, bei dem das Sekundärpumpenventil (43) ein Schieberventil ist.

13. Vakuumbeschichtungsgerät gemäß einem der Ansprüche 3 bis 11, bei dem das Sekundärpumpenventil ein Klappenventil oder ein Pendelventil ist.

14. Vakuumbeschichtungsgerät (10; 200; 300) gemäß einem der Ansprüche 3 bis 13, bei dem die Gaseinspritzmittel (52, 53) der Leckerfassungsvorrichtung (50) ebenfalls dazu ausgelegt sind, ein Inertgas in die Vakuumbeschichtungskammer (30) einzubringen, wobei das Inertgas mit dem Helium ein Gasgemisch bildet.

15. Vakuumbeschichtungsgerät (10; 200; 300) gemäß einem der Ansprüche 3 bis 14, bei dem die Leckerfassungsvorrichtung (50) ebenfalls Steuermittel (57) aufweist, die dazu ausgelegt sind, die Gaseinspritzmittel (52, 53) und das Öffnen und Schließen des Ventils (28; 228) für den inneren Tank, des Sekundärpumpenventils (43), des Primärpumpenventils (44) und des Umlenkungsventils (45) zu steuern.

## Claims

1. A method for detecting a leak in a valve-cell vacuum deposition apparatus (10), the vacuum deposition apparatus (10) including at least one valve cell (20) comprising:
- an outer enclosure (21),
- an inner tank (24; 224) located inside the outer enclosure (21), the inner tank (24; 224) containing a material to be evaporated (26),
- an inner tank valve (28; 228) comprising a valve input port (28A; 228A) in fluidic communication with the inner tank (24; 224) and a valve output port (28B; 228B),
- a vacuum deposition chamber (30), and
- a leak detection device (50),
said leak detection method being **characterized in that** it includes:
- an initialization step in which:
- vacuum is made inside the vacuum deposition chamber (30), then
- an initial leak flow rate in the vacuum deposition chamber (30) is measured by means of the leak detection device (50), and
- a measurement step in which:
- the inner tank valve (28; 228) is open to place the vacuum deposition chamber (30) in fluidic communication with the inner tank (24; 224), then
- a gaseous mixture is injected into the vacuum deposition chamber (30), then
- a pressure P0 is measured inside the inner tank (24; 224), then
- the inner tank valve (28; 228) is closed, then
- vacuum is made inside the vacuum deposition chamber (30) to a predetermined pressure in the vacuum deposition chamber (30), then
- the vacuum deposition chamber (30) is placed in fluidic communication with the leak detection device (50), then
- a final leak flow rate in the vacuum deposition chamber (30) is measured by means of the leak detection device (50), then
- a leak rate of the inner tank valve (28; 228) is deducted therefrom.

2. The leak detection method according to claim 1, wherein, at the end of the measurement step, the leak rate of the inner tank valve (28, 228) and of the inner tank (24; 224) is deduced.

3. A valve-cell vacuum deposition apparatus (10; 200; 300) adapted to implement the leak detection method according to one of claims 1 and 2, and including :
- at least one valve cell (20; 220; 320) comprising:
- an outer enclosure (21),
- an inner tank (24; 224) located inside the outer enclosure (21) and adapted to contain a material to be evaporated (26),
- an inner tank valve (28; 228) comprising a valve input port (28A; 228A) in fluidic communication with the inner tank (24; 224) and a valve output port (28B; 228B),
- a vacuum deposition chamber (30),
- a transfer tube (11) comprising a tube input port (11A) and connected to the valve output port (28B; 228B) of the inner tank valve (28, 228) and a tube output port (11 B), so that the tube output port (11B) is located in the vacuum deposition chamber (30), the tube output port (11 B) including an injector (12) adapted to generate a jet of vapour of the material to be evaporated (26) inside the vacuum deposition chamber (30), the vacuum deposition chamber (30) being connected to the outer enclosure (21) by means of a connection flange (13),
- pumping means (40) adapted to vacuum the inside of the vacuum deposition chamber (30), the pumping means (40) comprising:
- a primary pump (41) having a primary pump input (41A) and a primary pump outlet (41B), and
- a secondary pump (42) having a secondary pump input (42A) and a secondary pump output (42B), the secondary pump output (42B) being connected to the primary pump input (41A),
**characterized in that** it includes a leak detection device (50) comprising:
- gas injection means (52, 53), adapted to introduce helium into the vacuum deposition chamber (30),
- gas pumping means adapted to pump the helium present in the vacuum deposition chamber (30),
- a helium detector (51) comprising a detector input (51A), the helium detector (51) delivering a signal representative of the helium flow rate passing through it,
- pressure measurement means (54, 54A) adapted to measure the pressure inside the vacuum deposition chamber (30), and
- signal processing means (55) adapted to process the signal relating to the helium flow rate delivered by the helium detector (51) and the signal delivered by the pressure measurement means (54, 54A), to deliver a signal representative of the leak rate of the inner tank valve (28; 228),
and **in that** the pumping means (40) also include:
- a secondary pump valve (43) placed between the vacuum deposition chamber (30) and the secondary pump input (42A),
- a primary pump valve (44) placed between the secondary pump output (42B) and the primary pump input (41A), and
- a by-pass valve (45) placed between the secondary pump output (42B) and the detector input (51A), the by-pass being made upstream the primary pump valve (44).

4. The vacuum deposition apparatus (10; 300) according to claim 3, wherein the inner tank valve (28) is located inside the outer enclosure (21), its valve input port (28A) being connected to the inner tank (24).

5. The vacuum deposition apparatus (10; 300) according to one of claims 3 and 4, wherein the tube input port (11A) of the transfer tube (11) is located inside the outer enclosure (21), the transfer tube (11) passing through a first wall (21A) of the outer enclosure (21) and a second wall (30A) of the vacuum deposition chamber (30).

6. The vacuum deposition apparatus (10) according to one of claims 3 to 5, wherein:
- the pressure measurement means (54, 54A) deliver a signal representative of the pressure inside the inner tank (24), and
- the signal processing means (55) process the signal representative of the pressure inside the inner tank (24) delivered by the pressure measurement means (54, 54A) to deliver a signal representative of the leak rate of the inner tank valve (28) and of the inner tank (24).

7. The vacuum deposition apparatus (10) according to one of claims 3 to 6, wherein the outer enclosure (21) is in fluidic communication with the vacuum deposition chamber (30).

8. The vacuum deposition apparatus (200; 300) according to one of claims 3 to 6, wherein isolation means (228; 311 C) adapted to insulate the outer enclosure (21) from the vacuum deposition chamber (30) are provided.

9. The vacuum deposition apparatus (200) according to claim 8, wherein the isolation means comprise the inner tank valve (228).

10. The vacuum deposition apparatus (200) according to claim 8, wherein the isolation means comprise a weld (311C) between the outer enclosure (21) and the transfer tube (11).

11. The vacuum deposition apparatus (10; 200; 300) according to one of claims 3 to 10, wherein the secondary pump (42) is a turbo-molecular pump.

12. The vacuum deposition apparatus (10; 200; 300) according to one of claims 3 to 11, wherein the secondary pump valve (43) is a slide gate valve.

13. The vacuum deposition apparatus according to one of claims 3 to 11, wherein the secondary pump valve is a butterfly valve or a pendulous valve.

14. The vacuum deposition apparatus (10; 200; 300) according to one of claims 3 to 13, wherein the gas injection means (52, 53) of the leak detection device (50) are also adapted to introduce an inert gas in the vacuum deposition chamber (30), the inert gas forming a gaseous mixture with the helium.

15. The vacuum deposition apparatus (10; 200; 300) according to one of claims 3 to 14, wherein the leak detection device (50) also includes controlling means (57) adapted to control the gas injection means (52, 53) and the opening and closure of the inner tank valve (28, 228), of the secondary pump valve (43), of the primary pump valve (44) and of the by-pass valve (45).
